# EUROPÄISCHE PATENTSCHRIFT

(11) **EP 3 602 785 B1**
(45) Veröffentlichungstag und Bekanntmachung des Hinweises auf die Patenterteilung: **28.04.2021**
(21) Anmeldenummer: 17832219.4
(22) Anmeldetag: 20.12.2017
(51) Int. Cl.: H03K 17/96

(54) **TÜRGRIFFANORDNUNG FÜR EIN KRAFTFAHRZEUG MIT KAPAZITIVEM SENSOR UND NAHFELDKOMMUNIKATION**
DOOR HANDLE ASSEMBLY FOR A MOTOR VEHICLE HAVING A CAPACITIVE SENSOR AND NEAR-FIELD COMMUNICATION
ENSEMBLE DE POIGNÉE DE PORTE POUR VÉHICULE AUTOMOBILE MUNI D'UN CAPTEUR CAPACITIF ET D'UN SYSTÈME DE COMMUNICATION EN CHAMP PROCHE

(30) Priorität: 30.03.2017 DE 102017106869
(43) Veröffentlichungstag der Anmeldung: 05.02.2020
(73) Patentinhaber: HUF Hülsbeck & Fürst GmbH & Co. KG, 42551 Velbert (DE)
(72) Erfinder: SIEG, Herr Berthold, 46240 Bottrop (DE)
(74) Vertreter: Zenz Patentanwälte Partnerschaft mbB
(86) Internationale Anmeldenummer: PCT/EP2017/083689
(87) Internationale Veröffentlichungsnummer: WO 2018/177580

(56) Entgegenhaltungen:
- WO-A1-2012/048770
- WO-A1-2015/168459
- GB-A- 2 409 842
- US-A1- 2009 167 699
- US-A1- 2013 162 594
- US-A1- 2017 235 386

## Beschreibung

Die Erfindung betrifft eine Türgriffanordnung für ein Kraftfahrzeug mit einer Sensoreinrichtung, welche eine wenigstens einschichtige Leiterplatte aufweist, auf welcher eine Sensorelektrode wenigstens eines kapazitiven Sensors ausgebildet ist. Eine induktive Nahfeld-Übertragungseinrichtung ist mit einer Nahfeld-Übertragungsspule mit wenigstens einer Windung ausgebildet, die sich auf der wenigstens einschichtigen Leiterplatte erstreckt. Eine Steuerelektronik ist sowohl mit der Sensorelektrode als auch der Nahfeld-Übertragung6seinrichtung gekoppelt.

Sensoreinrichtungen mit integrierten kapazitiven Sensoren sind allgemein bekannt, insbesondere deren Anwendung in Türaußengriffen von Kraftfahrzeugen. Beispielsweise offenbart die DE 196 17 038 A1 einen Türgriff mit kapazitiven Sensoren, um eine Annäherung eines potentiellen Bedieners zu erfassen.

Ein solcher kapazitiver Annäherungssensor umfasst dabei eine Sensorelektrode und eine Ansteuer- und Auswerteschaltung. Die Ansteuer- und Auswerteschaltung misst die Kapazität der Elektrode gegenüber Masse. Durch Annäherung einer Hand des Bedieners wird die Kapazität der Elektrode verändert, und die Kapazitätsänderung wird durch die Ansteuer- und Auswerteschaltung erfasst.

Sobald der Sensor eine Annäherung erfasst hat, kann in Abhängigkeit davon ein Wecksignal eines Keyless-Entry-Systems ausgesandt werden.

Das Dokument GB 2 409 842 A offenbart eine Erfassungsvorrichtung für Hindernisse im Fahrweg eines Fahrzeuges. Eine Sensoreinrichtung ist im Stoßfänger des Fahrzeuges angeordnet. Die Sensoreinrichtung weist einen induktiven Sensor in Spulenform und einen im Spuleninnern aufgenommenen kapazitiven Sensor auf.

Die WO 2012/048770 A1 betrifft eine Sensoranordnung mit Sensorelektroden, welche in einer Mehrlagenplatine angeordnet sind.

Aus der US 2013/162594 A1 ist eine Bedieneinheit bekannt, welche eine Nahfeldkommunikationseinrichtung und einen Touchscreen integriert. Die Nahfeldkommunikationseinrichtung ist unterhalb der Anzeige des Touchscreens angeordnet.

Das Dokument WO 2015/168459 A1 offenbart eine Fahrzeugkomponente mit einem kapazitiven Sensor und einer induktiven Nahfeld-Übertragungseinrichtung.

Es ist außerdem bekannt, dass Benutzer von Kraftfahrzeugen im Alltag möglichst wenig durch mitgeführte Geräte und Schlüssel für Kraftfahrzeuge belastet werden möchten. Daher besteht der Wunsch, Funktionen des Kraftfahrzeuges auch durch die Verwendung von Geräten mit anderer Hauptfunktion zu legitimieren, die vom Benutzer mitgeführt werden. Dies können beispielsweise Mobiltelefone sein. Zum Informationsaustausch zwischen einem Mobilgerät und dem Fahrzeug können Nahfeld-Übertragungseinrichtungen als Kommunikationsschnittstelle eingesetzt werden. Insbesondere sind dazu Kommunikationsschnittstellen gemäß dem NFC-Standard etabliert und in zahlreichen Mobilgeräten bereits eingebaut.

Ein Fahrzeugtürgriff mit sowohl einer kapazitiven Elektrode als auch einer Nahfeld-Übertragungseinrichtung beschreibt beispielsweise die WO 2014/146949 A1. Dort sind auf ein und derselben Leiterplatte sowohl eine Übertragungsspule einer Nahfeldeinrichtung als auch eine kapazitive Sensorelektrode angeordnet.

Der Bauraum innerhalb eines Bedienelementes am Fahrzeug, z.B. einem Türgriff, ist begrenzt. Allerdings können sowohl der kapazitive Sensor als auch die Nahfeld-Übertragungseinrichtung umso sensitiver ausgebildet werden, je mehr Platz für deren sensitive Elemente, also die Sensorelektrode und die Nahfeld-Übertragungsspule, zur Verfügung steht.

Aufgabe der Erfindung ist es, eine verbesserte Sensoreinrichtung für Kraftfahrzeuge zur Verfügung zu stellen, die eine verbesserte Bauraumnutzung mit optimierter Sensitivität aufweist.

Diese Aufgabe wird gelöst durch einen Fahrzeugtürgriff mit Sensoreinrichtung mit den Merkmalen des Patentanspruches 1.

Die erfindungsgemäße Sensoreinrichtung der eingangs genannten Art ist so ausgebildet, dass die Sensorelektrode in einem von der Windung der NFC-Nahfeld-Übertragungsspule umgriffenen Innenbereich ausgebildet ist.

Sowohl die NFC-Nahfeld-Übertragungsspule als auch die Sensorelektrode können als Leiterbahnen und Leiterflächen auf der Leiterplatte ausgebildet sein. Sie können dabei sowohl auf derselben Ebene der Leiterplatte ausgebildet sein, als auch, bei einer mehrschichtigen Leiterplatte, auf verschiedenen Ebenen der Leiterplatte. Durch die Nahfeld-Übertragungsspule wird jedoch in jedem Fall ein Innenbereich definiert, der innerhalb der Windung liegt, jedoch nicht von dieser bedeckt ist. Es handelt sich also um den windungsfreien Innenbereich und dessen in der Windungsachse verlaufende Projektionen über die Schichten oder Ebenen der Leiterplatte. Die Sensorelektrode ist in diesem freien Innenbereich der Nahfeld-Übertragungsspule ausgebildet.

Erfindungsgemäß ist die Sensorelektrode dabei mit einer besonderen Geometrie ausgebildet, um die Wirbelströme in der Sensorelektrode zu minimieren. Beim Betrieb der Nahfeld-Übertragungseinrichtung kommt es in der Sensorelektrode im freien Innenbereich der Spule zur Induktion von Wirbelströmen. Diese Wirbelströme bringen ein Magnetfeld hervor, welches dem erzeugenden Magnetfeld entgegenwirkt und damit die Kommunikationsfähigkeit der Nahfeld-Übertragungseinrichtung erheblich einschränkt. Erfindungsgemäß ist die Sensorelektrode mit einem langgestreckten Mittelleiter ausgebildet und einer Mehrzahl von Abzweigleitern, die sich von dem Mittelleiter aus erstrecken. Dabei sind die Abzweigleiter entlang des Mittelleiters beabstandet voneinander angeordnet, so dass die Abzweigleiter gleichsam wie Zweige von dem Mittelleiter abstehen und nur über den Mittelleiter galvanisch miteinander gekoppelt sind. Die Abzweigleiter weisen auf ihrer dem Mittelleiter abgewandten Seite freie (nicht elektrisch mit weiteren Bauteilen gekoppelte) Enden auf. Außerdem sind die Abzweigleiter jeweils paarweise zu voneinander abgewandten Seiten an dem Mittelleiter angeordnet, so dass zu jedem Abzweigleiter ein zugeordneter Abzweigleiter auf der jeweils abgewandten Seite des Mittelleiters ausgebildet ist. Sämtliche Leiter, Mittelleiter und Abzweigleiter, können als Leiterbahnen auf einer Ebene der Leiterplatte ausgebildet sein.

Der Mittelleiter bildet mit den Abzweigleitern zusammen die Sensorelektrode und bildet eine Art von Tannenzweig-Struktur oder zweiseitiger Kamm-Struktur. Grundsätzlich können dabei die Abzweigleiter eine beliebige Form einnehmen, sie dürfen jedoch miteinander und mit dem Mittelleiter keine geschlossenen Ringstrukturen bilden, in denen sich größere Wirbelstrombereiche ausbilden können.

Erfindungsgemäß wird auf diese Weise eine Sensorelektrode gebildet, die ein Detektionsgebiet teilweise mit Leiterstrukturen belegt, ohne jedoch Raum für die Ausbildung größerer Wirbelstrombereiche zu bieten. Es hat sich gezeigt, dass auf diese Weise sowohl eine verlässliche Detektion des kapazitiven Sensors möglich ist, als auch ein sensitiver Betrieb der Nahfeld-Übertragungsspule. Da ein und derselbe Flächenbereich der Leiterplatte sowohl für die kapazitive Sensorelektrode als auch für die Nahfeld-Übertragungseinrichtung genutzt werden kann, ist eine kompaktere Bauform der Sensoreinrichtung möglich, oder aber eine weitere Erstreckung des sensitiven Bereiches sowohl der Nahfeld-Übertragungseinrichtung als auch der kapazitiven Sensoreinrichtung.

Sowohl die Nahfeld-Übertragungsspule als auch die Sensorelektrode können in herkömmlicher Weise, also beispielsweise wie im oben genannten Stand der Technik beschrieben, angesteuert werden. Ein weiterer Vorteil der erfindungsgemäßen Anordnung besteht darin, dass die zwischen den Leitpfaden der Nahfeld-Übertragungsspule und der Sensorelektrode auftretenden parasitären Kapazitäten reduziert werden.

In einer vorteilhaften Weiterbildung der Erfindung sind alle Paare von Abzweigleitern jeweils zueinander symmetrisch ausgebildet. Dies bedeutet, dass bezogen auf den Ansatzpunkt der Abzweigleiter am Mittelleiter jedes Paar von Abzweigleitern symmetrisch hinsichtlich seiner Länge, Breite und seiner Formgebung ist.

Auf diese Weise können ungewollt induzierte Spannungen in den leitenden Elektrodenflächen des kapazitiven Sensors während des Betriebs der Nahfeldeinrichtung reduziert werden.

In einer Weiterbildung der Erfindung sind die Abzweigleiter sämtlich gerade gestreckt ausgebildet und in einem einheitlichen Abzweigwinkel zu dem Mittelleiter angeordnet. Die einheitliche gerade Ausbildung der Abzweigleiter und der einheitliche Abzweigwinkel führen zu einem einheitlichen Abstand der Mittelleiter zueinander. Entsprechend sind induktive und kapazitive Effekte zwischen den Mittelleitern einheitlich über deren Länge mit geringstmöglicher Schwankung anzutreffen.

In einer Weiterbildung dieser Gestaltung beträgt der Abzweigwinkel 90°, so dass die Abzweigleiter mit dem Mittelleiter eine zweiseitige Kammstruktur bilden. Eine derartige Anordnung sorgt dafür, dass bezüglich des Mittelleiters über seine gesamte Länge eine einheitliche Wirkung der Abzweigleiter auftritt, da die Abzweigleiterdichte im Bereich um den Mittelleiter geringstmöglich variiert. Bei schrägen Abzweigleitern hingegen kann es versetzt zum Mittelleiter zu Flächenbereichen kommen, die eine unterschiedliche Flächendichte der Abzweigleiter aufweisen. Dies kann in Einzelfällen gewünscht oder vorteilhaft sein. Die Abzweigwinkel von 90° gewährleisten jedoch eine einheitliche Flächendichte und eine besonders zuverlässige Aufhebung unerwünscht induzierter Spannungen in der Sensorelektrode.

In einer bevorzugten Gestaltung der erfindungsgemäßen Sensoreinrichtung sind die Abzweigleiter, ausgehend von dem Mittelleiter, über die gesamte Länge mit konstanter Breite ausgebildet. Während die Sensoreinrichtung grundsätzlich Abzweigleiter aufweisen kann, die verbreiterte Bereiche und verjüngte Bereiche aufweisen, ist in dieser Gestaltung eine konstante Breite der Abzweigleiter vorgesehen. Auch diese Gestaltung ermöglicht eine vereinfachte Herstellung und gewährleistet, dass der Abstand der Abzweigleiter zueinander über deren Erstreckungslänge konstant bleibt.

Eine weitere bevorzugte Gestaltung der erfindungsgemäßen Sensoreinrichtung sieht vor, dass sämtliche Abzweigleiter von ihren benachbarten Abzweigleitern einheitliche Abstände aufweisen. Während im allgemeinen die Abstände der Abzweigleiterpaare entlang des Mittelleiters variieren können, ist die Gleichverteilung der Abzweigleiter über die Länge des Mittelleiters für eine bestmögliche Flächenbelegung der Sensorelektrode vorteilhaft.

Gemäß einer bevorzugten Ausführungsform der Erfindung sind die Abstände zwischen benachbarten Abzweigleitern derart bemessen, dass sie einem 0,1-Fachen bis 10-Fachen der Breite der benachbarten Abzweigleiter entsprechen. Die von den Abzweigleitern belegte Fläche und die zwischen den Abzweigleitern ausgebildete freie Fläche kann entsprechend mit einer anteilig größeren Flächenbelegung der freien Fläche oder anteilig größeren Belegung durch die Abzweigleiter einhergehen. Welche dieser Gestaltungen zu wählen ist, hängt von der Dimensionierung der Sensorelektrode und der Gesamtvorrichtung ab, kann jedoch einfach in Simulationsberechnungen empirisch optimiert werden.

Wesentlich ist, dass im Rahmen der Fertigungstoleranzen die benachbarten Abzweigleiter jederzeit galvanisch getrennt werden, bis auf die Verbindung über den Mittelleiter.

Die Nahfeld-Übertragungsspule kann mit einem rechteckigen Spulenquerschnitt auf der Leiterplatte ausgebildet sein und dabei kann der Mittelleiter der Sensorelektrode entlang einer Symmetrieachse des Spulenquerschnittes ausgebildet sein. Wird entsprechend die Nahfeld-Übertragungsspule gemäß einem rechteckigen Flächeninhalt um einen Bereich der Leiterplatte geführt, kann entlang der Mittelachse dieses Rechteckes der Mittelleiter der Sensorelektrode ausgebildet werden, wobei sich dann zu zwei Seiten dieses Mittelleiters die Abzweigleiter erstrecken. Die Anordnung an dieser Position ist vorteilhaft, weil eine symmetrische Mittelachse das Induktionsspannungsminimum bildet und so in der Sensorelektrode ungewollte induzierte Spannungen möglichst klein gehalten werden.

Es ist in einer Weiterbildung der Erfindung möglich, eine Mehrschichtplatine zur Ausbildung der Sensoreinrichtung vorzusehen, wobei die Sensorelektrode auf einer Lage der Mehrschichtplatine angeordnet ist und auf wenigstens einer weiteren Ebene der Mehrschichtplatine, insbesondere darunter, zu der Sensorelektrode eine deckungsgleiche Elektrode als Schirmelektrode (auch Shield-Elektrode) oder auch als Bezugselektrode ausgebildet ist. Die Schirmelektrode kann auch zu allen Seiten mit einem Überstand ausgebildet sein, was die Schirmwirkung weiter verbessert. Bei einem Abstand der Schichten von z.B. 600 µm sollte der Überstand allseitig mindestens 0,5 mm betragen.

Die Anordnung von kapazitiven Sensoreinrichtungen mit Schirmelektroden und Sensorelektroden sowie Bezugselektrode ist im Stand der Technik bekannt. Im Rahmen der Erfindung werden die Elektroden deckungsgleich oder allseitig überstehend, das heißt, mit im wesentlichen gleicher Geometrie und senkrecht zur Leiterplattenebene deckungsgleich ausgerichtet. Auf diese Weise erzielt die Sensoreinrichtung die bekannten Vorteile einer Sensoreinrichtung mit Sensorelektrode und Schirmelektrode sowie Bezugselektrode, gleichzeitig werden die genannten Vorteile der Erfindung erreicht. Außerdem kann die Nahfeld-Übertragungsspule Windungen auf verschiedenen Ebenen der Leiterplatte aufweisen.

Gemäß einer vorteilhaften Ausbildung der Erfindung ist außerdem die Steuereinrichtung der Sensoreinrichtung so ausgebildet, dass die Sensorelektrode immer dann auf ein Massepotential gelegt wird, wenn die Nahfeld-Übertragungsspule zur Übertragung aktiviert ist. Außerdem sollte die Nahfeld-Übertragungsspule immer dann auf ein Massepotential gelegt werden, wenn die Sensorelektrode zur Sensierung aktiviert ist. Das jeweils nicht aktive Element, die Nahfeld-Übertragungsspule einerseits und die Sensorelektrode andererseits, werden deaktiviert und auf ein Massepotential gelegt, um den Betrieb des jeweils aktiven Elementes nicht zu stören.

Die Erfindung wird nun anhand der beiliegenden Zeichnungen näher erläutert.
Figur 1 zeigt schematisch einen Fahrzeugtürgriff mit einer erfindungsgemäßen Sensoranordnung und deren Erfassungsfeld;
Figur 2 zeigt schematisch einen Aufbau einer erfindungsgemäßen Sensoranordnung gemäß einer ersten Ausführungsform;
Figur 3 zeigt schematisch den Aufbau einer erfindungsgemäßen Sensoranordnung gemäß einer zweiten Ausführungsform;
Figuren 4a, 4b und 4c zeigen schematisch eine Magnetfeldverteilung einer Nahfeld-Übertragungsspule bei unterschiedlichen Belegungen eines Innenraums mit Leiterstrukturen.

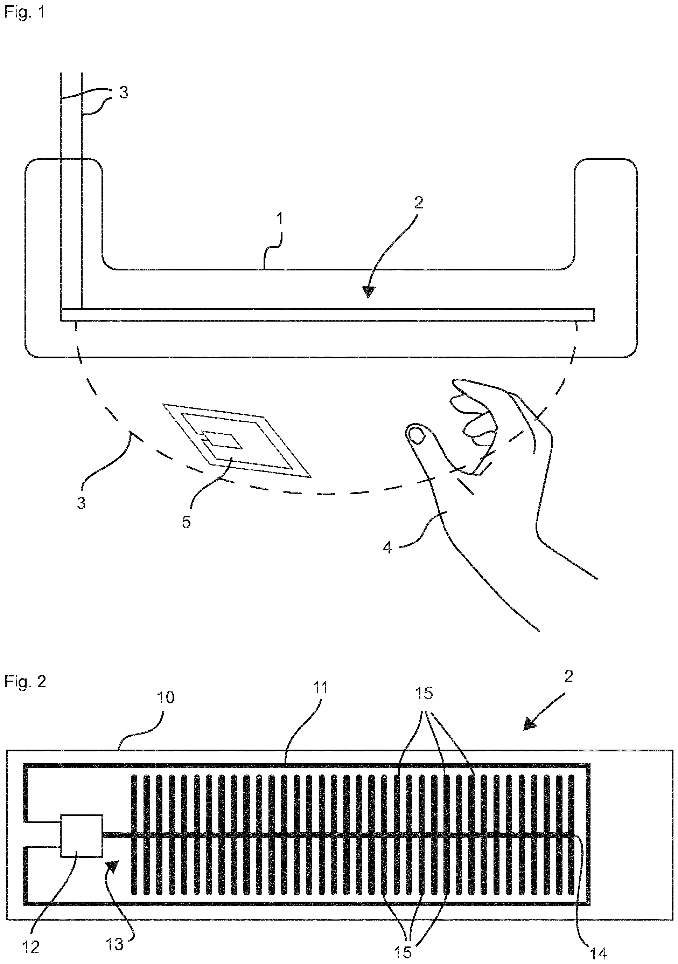

In Figur 1 ist ein Fahrzeugtürgriff 1 gezeigt. In dem Fahrzeugtürgriff 1 ist eine erfindungsgemäße Sensoranordnung 2 angeordnet. Von der Sensoranordnung 2 führen Zuleitungen 3 zu einer fahrzeugseitigen zentralen Steuereinrichtung.

Die erfindungsgemäße Sensoreinrichtung 2, welche unter Bezug auf die weiteren Figuren näher beschrieben wird, bildet ein Detektionsfeld 6 aus. Die Sensoreinrichtung 2 weist dazu sowohl einen kapazitiven Sensorbereich auf, der die Annäherung einer Hand 4 erfasst, als auch eine Nahfeld-Übertragungseinrichtung, die eine NFC-Mobileinrichtung 5 erfasst. Die entsprechenden Schnittstellen werden an der Sensoreinrichtung wechselweise, also zeitversetzt, aktiviert.

Wie der Figur 1 zu entnehmen, dehnt sich der Erfassungsbereich 6 über nahezu die gesamte Erstreckung der Sensoreinrichtung 2 aus. Der Erfassungsbereich 6 ist hier schematisch einheitlich für die Erfassung einer Nahfeld-Übertragung als auch die kapazitive Erfassung gezeigt, dies ist jedoch nur sinnbildlich zu verstehen. Jedenfalls weisen die kapazitiven Erfassungsbereiche und die Erfassung einer Nahfeld-Übertragungseinrichtung 5 überlappende Bereiche auf.

In Figur 2 ist die Sensoreinrichtung 2 aus Figur 1 gemäß einem ersten Ausführungsbeispiel dargestellt. Eine Leiterplatte 10 ist in dieser Darstellung als einschichtige Leiterplatte gebildet. Im Randbereich der Leiterplatte 10 läuft eine Windung 11 einer Nahfeld-Übertragungsspule um. Die Windung 11 ist mit der Steuerelektronik 12 gekoppelt, mit der zusammen sie eine Nahfeld-Übertragungseinrichtung bildet. Die Steuerelektronik 12 weist einen NFC-Reader Chip und einen mit diesem gekoppelten Mikrocontroller auf. Die Windung 11 ist mit dem NFC-Reader Chip und über diesen mit dem Mikrocontroller gekoppelt.

Ebenfalls mit der Steuerelektronik 12 ist eine Sensorelektrode 13 gekoppelt, wobei die Sensorelektrode nicht mit dem NFC-Reader Chip sondern unmittelbar mit dem Mikrocontroller gekoppelt ist. Diese weist einen Mittelleiter 14 und eine Vielzahl an Abzweigleitern 15 auf. Die Abzweigleiter sind nur teilweise mit Bezugszeichen versehen, um die Abbildung nicht unübersichtlich zu gestalten. Die Abzweigleiter 15 bilden zusammen mit dem Mittelleiter 14 die Sensorelektrode, die sich innerhalb des von der Nahfeld-Übertragungsspule 11 umgriffenen Bereiches der Leiterplatte 10 befindet. Der Mittelleiter 14 ist entlang der Symmetrieachse der Nahfeld-Übertragungsspule 11 ausgebildet.

Zwischen den Abzweigleitern 15 sind unbelegte, leiterfreie Zwischenräume ausgebildet, so dass die Abzweige nur über den Mittelleiter 14 galvanisch gekoppelt sind. Die Abzweigleiter weisen in dieser Ausführungsform sämtlich dieselbe Länge auf und erstrecken sich spiegelsymmetrisch von dem Mittelleiter 14 zur Ausbildung einer doppelten Kammstruktur. Die Abstände der Abzweigleiter 15 sind in dieser Darstellung sämtlich einheitlich, ebenso wie die Länge. Außerdem sind die Abzweigleiter 15 gerade ausgebildet.

Die Sensorelektrode 13 wird zur Detektion im zeitlichen Wechsel mit der Nahfeld-Übertragungseinrichtung und der zugehörigen Nahfeld-Übertragungsspule 11 aktiviert. Durch die grätenartige Struktur der Sensorelektrode 13 ist es möglich, das durch die Nahfeld-Übertragungsspule 11 aufgebaute Magnetfeld zur Kopplung mit einem NFC-fähigen Gerät ohne größere Störungen (Performanceverslust) aufzubauen.

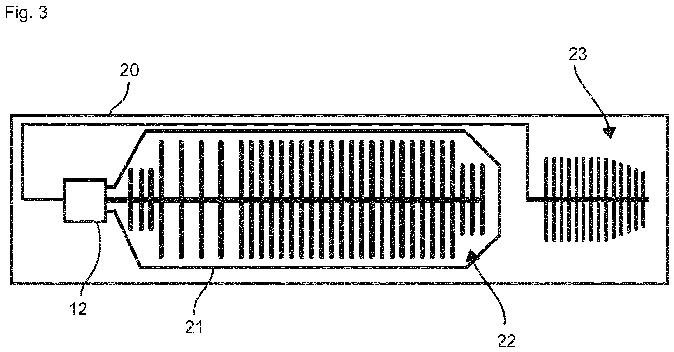

Figur 3 zeigt eine alternative Gestaltung einer Sensoreinrichtung gemäß einem alternativen Ausführungsbeispiel. In dieser Gestaltung ist eine Leiterplatte 20 ausgebildet, die eine Steuereinrichtung 12 aufweist. Eine Windung 21 ist als Leiterbahn auf der Leiterplatte 20 zur Bildung einer Nahfeld-Übertragungsspule ausgebildet. Innerhalb des inneren freien Bereiches der Nahfeld-Übertragungsspule 21 ist eine Sensorelektrode 22 ausgebildet. In dieser Darstellung ist ersichtlich, dass die Sensorelektrode 22 einen Mittelleiter mit unterschiedlich langen Abzweigleitern aufweist. Außerdem sind die Abzweigleiterpaare mit unterschiedlichen Abständen entlang des Mittelleiters angeordnet. Der Mittelleiter ist entlang der Symmetrieachse der Nahfeld-Übertragungsspule 21 ausgebildet. Weiterhin ist die Steuerelektronik 12 mit einer zweiten Sensorelektrode 23 ausgebildet, die außerhalb der Nahfeld-Übertragungsspule liegt. Auch diese weist eine symmetrische Struktur mit einer Vielzahl von Abzweigleitern auf, die beabstandet voneinander angeordnet sind.

An diesem Ausführungsbeispiel wird deutlich, dass die Erfindung mit unterschiedlichen Abständen zwischen den Abzweigleitern realisiert werden kann und auch mit unterschiedlichen Längen der Abzweigleiter. Die Abzweigleiter sind jedoch paarweise symmetrisch an dem Mittelleiter angeordnet.

Das gezeigte Beispiel dient in der Praxis dazu, beispielsweise im Türgriff, einen Bereich für eine Türöffnung, detektiert durch die Sensorelektrode 22, von einem Bereich für die Türschließung, detektiert durch die Elektrode 23, abzugrenzen. Es wäre grundsätzlich möglich, auch um die Elektrode 23 eine weitere Nahfeld-Übertragungsspule auszubilden.

Die Figuren 2 und 3 zeigen entsprechend unterschiedliche Ausführungsformen der erfindungsgemäßen Sensoreinrichtung. Es wird deutlich, dass die Einrichtungen mit unterschiedlichem Teilungsverhältnis gebildet werden können. Welche Breite die Abzweigleiter und der Mittelleiter aufweisen ist anwendungsabhängig. Typische Breiten der Abzweigleiter betragen zum Beispiel 0,3 mm bis 2 mm. Auch die Abstände können zum Beispiel 0,3 mm bis 2 mm betragen. Die Breiten der Abzweigleiter können jedoch auch deutlich größer gewählt werden, zum Beispiel bis 3 oder 5 mm und die Abstände können kleiner sein.

Auch die Anzahl der Abzweigleiter kann variiert werden. Üblicherweise ist es jedoch erforderlich, wenigstens eine Anzahl von fünf Abzweigleiterpaaren an einem Mittelleiter vorzusehen, wobei erheblich mehr Abzweigleiterpaare, beispielsweise 20 bis 100 Abzweigleiterpaare vorgesehen werden können.

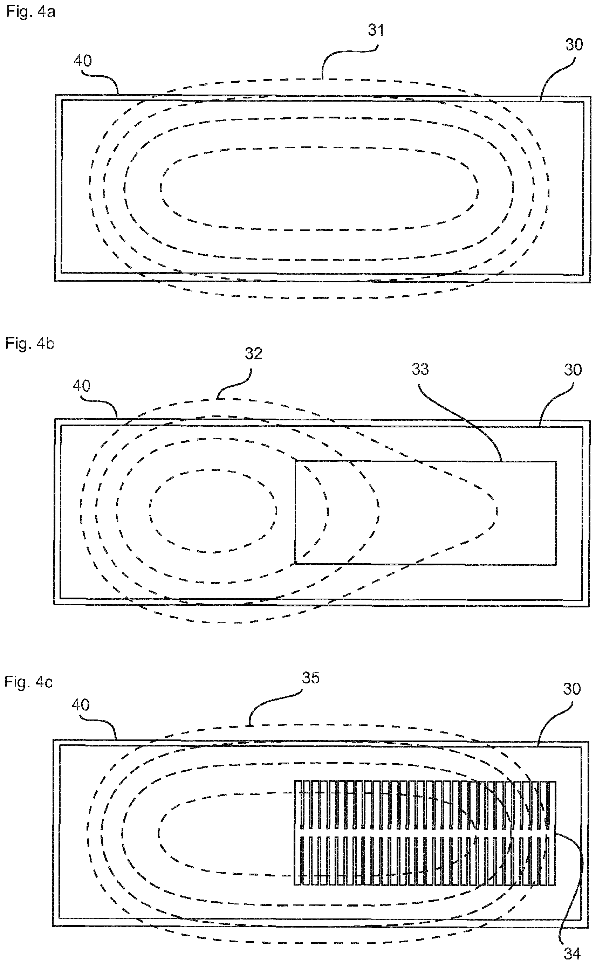

Die Figuren 4a bis 4c zeigen in schematischer Wiedergabe die Ergebnisse von Simulationsrechnungen. Dargestellt ist eine Leiterschleife 30 auf einer Leiterplatte 40, die mit einer entsprechenden Bestromung ein Magnetfeld aufbaut. Die gestrichelten Linien 31 zeigen die Verläufe gleicher Magnetfeldstärken.

In Figur 4a ist im Inneren der Leiterschleife 30 der einer Leiterplatte 40 kein elektrisch leitfähiges Material aufgebracht. Entsprechend bildet sich ein Magnetfeld gemäß dem Linien 31 aus.

In Figur 4b ist hingegen eine herkömmliche Sensorelektrode mit einer Elektrodenfläche 33 als Vollfläche ausgebildet. Bei einer solchen Vollfläche 33 wird das Magnetfeld gemäß der Linie 32 erheblich geschwächt und konzentriert sich im Wesentlichen auf den unbelegten freien Bereich innerhalb der Windung 30.

In Figur 4c ist hingegen die erfindungsgemäße Sensoranordnung gezeigt, wobei die Vollfläche 33 durch eine Sensorelektrode 34 mit einem Mittelleiter und einer Vielzahl von Abzweigleitern ersetzt wurde. Die Abzweigleiter weisen jeweils Abstände zueinander auf, die eine Ausbildung von Wirbelströmen großen Durchmessers verhindern. Außerdem ist der Mittelleiter entlang einer Symmetrieachse der Spule 30 angeordnet. Die Simulationsrechnungen ergeben, dass ein erzeugtes Magnetfeld 35 nur geringfügig geschwächt gegenüber dem Magnetfeld 31 aus Figur 4a ohne Sensorelektrode ausgebildet wird. Entsprechend kann sowohl die Kopplung der Windung 30 als auch die Sensorelektrode 34 bei besserer Ausnutzung des Bauraumes genutzt werden.

In Figur 4c ist beispielhaft eine Anordnung der Abzweigleiter gezeigt, wobei die Breiten der jeweiligen Abzweigleiter größer sind als die Abstände der Abzweigleiter voneinander. Dieses Verhältnis von Breiten der Abzweigleiter zu dem Abstand der Abzweigleiter kann jedoch, wie oben beschrieben, in einem erheblichen Rahmen variiert werden.

## Patentansprüche

1. Fahrzeugtürgriff mit Sensoreinrichtung, aufweisend
eine wenigstens einschichtige Leiterplatte (10; 20; 40), auf welcher eine Sensorelektrode (13; 22; 34) wenigstens eines kapazitiven Sensors ausgebildet ist,
eine induktive Nahfeld-Übertragungseinrichtung, wobei die induktive Nahfeld-Übertragungseinrichtung eine Nahfeld-Übertragungsspule (11; 21; 30) mit wenigstens einer Windung aufweist, wobei die wenigstens eine Windung auf der wenigstens einschichtigen Leiterplatte (10; 20; 40) ausgebildet ist,
eine Steuerelektronik (12), welche mit der Sensorelektrode (13; 22; 34) und der Nahfeld-Übertragungseinrichtung gekoppelt ist, wobei die Nahfeld-Übertragungsspule und die Sensorelektrode (13; 22; 34) derart zueinander angeordnet sind, dass die Sensorelektrode im von der Windung umgriffenen Innenbereich der Nahfeld-Übertragungsspule ausgebildet ist,
wobei die Sensorelektrode einen langgestreckten Mittelleiter (14) aufweist und eine Mehrzahl von Abzweigleitern (15), die sich von dem Mittelleiter erstrecken,
wobei die Abzweigleiter sich entlang des Mittelleiters derart beabstandet voneinander erstrecken, dass die Abzweigleiter (15) ausschließlich über den Mittelleiter (14) galvanisch gekoppelt sind,
wobei die Abzweigleiter jeweils paarweise zu voneinander abgewandten Seiten an dem Mittelleiter angeordnet sind, so dass zu jedem Abzweigleiter ein zugeordneter Abzweigleiter auf der jeweils abgewandten Seite des Mittelleiters ausgebildet ist.

2. Fahrzeugtürgriff nach Anspruch 1, wobei jedes Paar von Abzweigleitern bezüglich des Mittelleiters symmetrisch ausgebildet ist.

3. Fahrzeugtürgriff nach Anspruch 1 oder 2, wobei sämtliche Abzweigleiter gerade ausgebildet sind und in einem einheitlichen Abzweigwinkel zu dem Mittelleiter abzweigen.

4. Fahrzeugtürgriff nach Anspruch 3, wobei der Abzweigwinkel 90 Grad beträgt und somit die Abzweigleiter mit dem Mittelleiter eine zweiseitige Kammstruktur bilden.

5. Fahrzeugtürgriff nach einem der vorangehenden Ansprüche, wobei jeder Abzweigleiter sich mit einer über seine gesamte Länge konstanten Breite von dem Mittelleiter erstreckt.

6. Fahrzeugtürgriff nach einem der vorangehenden Ansprüche, wobei sämtliche Abzweigleiter eine einheitliche Breite aufweisen.

7. Fahrzeugtürgriff nach einem der vorangehenden Ansprüche, wobei sämtliche Abzweigleiter von ihren benachbarten Abzweigleitern einheitliche Abstände aufweisen.

8. Fahrzeugtürgriff nach einem der vorangehenden Ansprüche, wobei die Abstände zwischen benachbarten Abzweigleitern zwischen der 0,5-fachen und 5-fachen der größeren Breite der benachbarten Abzweigleiter aufweisen.

9. Fahrzeugtürgriff nach einem der vorangehenden Ansprüche, wobei die Abzweigleiter eine Breite zwischen 0,1 mmm und 1 mm aufweisen und wobei die Abstände zwischen benachbarten Abzweigleitern zwischen 0,1 mmm und 1 mm betragen.

10. Fahrzeugtürgriff nach einem der vorangehenden Ansprüche, wobei die Nahfeld-Übertragungsspule einen rechteckigen Spulenquerschnitt aufweist, wobei der Mittelleiter der Sensorelektrode entlang einer Symmetrieachse des Spulenquerschnitts ausgebildet ist.

11. Fahrzeugtürgriff nach einem der vorangehenden Ansprüche, wobei die Sensoreinrichtung auf einer Mehrschichtplatine ausgebildet ist, wobei die Sensorelektrode auf einer Lage der Mehrschichtplatine angeordnet ist und auf wenigstens einer weiteren Ebene der Mehrschichtplatine zu der Sensorelektrode eine deckungsgleiche Elektrode als Shield-Elektrode oder als Bezugselektrode ausgebildet ist.

12. Fahrzeugtürgriff nach einem der vorangehenden Ansprüche, wobei die Steuereinrichtung ausgebildet ist,
- die Sensorelektrode dann auf ein Massepotenzial zu legen, wenn die Nahfeld-Übertragungsspule zur Übertragung aktiviert ist, und
- die Nahfeld-Übertragungsspule dann auf ein Massepotenzial zu legen, wenn die Sensorelektrode zur Sensierung aktiviert ist.

## Claims

1. Vehicle door handle with sensor device, comprising
an at least single-layered printed circuit board (10; 20; 40) on which a sensor electrode (13; 22; 34) of at least one capacitive sensor is formed,
a near-field inductive transmission device, the inductive near-field transmission device comprising a near-field transmission coil (11; 21; 30) with at least one turn, the at least one turn being formed on the at least single-layered printed circuit board (10; 20; 40)
control electronics (12) coupled to the sensor electrode (13; 22; 34) and to the near-field transfer device
wherein the near-field transmission coil (11; 21; 30) and the sensor electrode (13; 22; 34) are arranged relative to one another in such a way that the sensor electrode is formed in the inner region of the near-field transmission coil, which is embraced by the winding,
said sensor electrode having an elongated center conductor (14) and a plurality of branch conductors (15) extending from said center conductor,
wherein the branch conductors extend along the center conductor spaced from each other such that the branch conductors (15) are galvanically coupled exclusively through the center conductor (14),
wherein the branch conductors are each arranged in pairs on the center conductor on sides facing away from each other, so that for each branch conductor an associated branch conductor is formed on the opposite side of the center conductor.

2. Vehicle door handle according to claim 1, wherein each pair of branch conductors is formed symmetrically with respect to the center conductor.

3. Vehicle door handle according to claim 1 or 2, wherein all branch conductors are formed straight and branch at a uniform branch angle to the center conductor.

4. Vehicle door handle according to claim 3, wherein the branch angle is 90 degrees and thus the branch conductors form a two-sided comb structure with the center conductor.

5. Vehicle door handle according to any one of the preceding claims, wherein each branch conductor extends from the center conductor with a constant width over its entire length.

6. Vehicle door handle according to any one of the preceding claims, wherein all branch conductors have a uniform width.

7. Vehicle door handle according to any one of the preceding claims, wherein all branch conductors are uniformly spaced from their adjacent branch conductors.

8. Vehicle door handle according to any one of the preceding claims, wherein the distances between adjacent branch conductors are between 0.5 times and 5 times the greater width of the adjacent branch conductors.

9. Vehicle door handle according to any one of the preceding claims, wherein the branch conductors have a width between 0.1 mmm and 1 mm, and wherein the distances between adjacent branch conductors are between 0.1 mmm and 1 mm.

10. Vehicle door handle according to any one of the preceding claims, wherein the near-field transmission coil has a rectangular coil cross-section, wherein the center conductor of the sensor electrode is formed along an axis of symmetry of the coil cross-section.

11. Vehicle door handle according to one of the preceding claims, wherein the sensor device is formed on a multilayer board, wherein the sensor electrode is arranged on one layer of the multilayer board and an electrode congruent with the sensor electrode is formed on at least one further layer of the multilayer board as a shield electrode or as a reference electrode.

12. Vehicle door handle according to any one of the preceding claims, wherein the control device is designed to
to connect the sensor electrode to a ground potential when the near-field transmission coil is activated for transmission, and
placing the near field transfer coil at a ground potential when the sensor electrode is activated for sensing.

## Revendications

1. Poignée de porte de véhicule avec dispositif de détection, comprenant
une carte de circuit imprimé au moins monocouche (10 ; 20 ; 40) sur laquelle une électrode de capteur (13 ; 22 ; 34) d'au moins un capteur capacitif est formée,
un dispositif de transmission inductif en champ proche, ledit dispositif de transmission inductif en champ proche comprenant une bobine de transmission en champ proche (11 ; 21 ; 30) ayant au moins un méandre, ledit au moins un méandre étant formé sur ladite carte de circuit imprimé au moins monocouche (10 ; 20 ; 40),
une électronique de commande (12) couplée à l'électrode de capteur (13 ; 22 ; 34) et au dispositif de transmission en champ proche,
**caractérisé**
**en ce que** la bobine de transmission de champ proche (11 ; 21 ; 30) et l'électrode de détection (13 ; 22 ; 34) sont disposées l'une par rapport à l'autre de telle sorte que l'électrode de détection est formée dans la zone intérieure de la bobine de transmission de champ proche qui est entourée par le méandre,
**en ce que** l'électrode de capteur comprend un conducteur central allongé (14) et une pluralité de conducteurs de dérivation (15) s'étendant depuis le conducteur central,
**en ce que** les conducteurs de dérivation s'étendent le long du conducteur central en étant espacés les uns des autres de telle sorte que les conducteurs de dérivation (15) sont couplés galvaniquement exclusivement par l'intermédiaire du conducteur central (14),
**en ce que** les conducteurs de dérivation sont chacun disposés par paires sur le conducteur central sur des côtés opposés l'un à l'autre, de telle sorte qu'un conducteur de dérivation associé est formé pour chaque conducteur de dérivation sur le côté du conducteur central opposé l'un à l'autre.

2. Poignée de porte de véhicule selon la revendication 1, dans laquelle chaque paire de conducteurs de dérivation est symétrique par rapport au conducteur central.

3. Poignée de porte de véhicule selon la revendication 1 ou 2, dans laquelle tous les conducteurs de dérivation sont droits et se ramifient selon un angle de dérivation uniforme par rapport au conducteur central.

4. Poignée de porte de véhicule selon la revendication 3, dans laquelle l'angle de branchement est de 90 degrés et les conducteurs de branchement forment ainsi une structure en peigne à deux côtés avec le conducteur central.

5. Poignée de porte de véhicule selon l'une quelconque des revendications précédentes, dans laquelle chaque conducteur de dérivation s'étend à partir du conducteur central avec une largeur constante sur toute sa longueur.

6. Poignée de porte de véhicule selon l'une quelconque des revendications précédentes, dans laquelle tous les conducteurs de dérivation ont une largeur uniforme.

7. Poignée de porte de véhicule selon l'une quelconque des revendications précédentes, dans laquelle tous les conducteurs de dérivation sont uniformément espacés de leurs conducteurs de dérivation adjacents.

8. Poignée de porte de véhicule selon l'une quelconque des revendications précédentes, dans laquelle l'espacement entre les conducteurs de branche adjacents est compris entre 0,5 fois et 5 fois la plus grande largeur des conducteurs de branche adjacents.

9. Poignée de porte de véhicule selon l'une quelconque des revendications précédentes, dans laquelle les conducteurs de dérivation ont une largeur comprise entre 0,1 mmm et 1 mm, et dans laquelle les distances entre les conducteurs de dérivation adjacents sont comprises entre 0,1 mmm et 1 mm.

10. Poignée de porte de véhicule selon l'une quelconque des revendications précédentes, dans laquelle la bobine de transmission de champ proche présente une section de bobine rectangulaire, le conducteur central de l'électrode de détection étant formé le long d'un axe de symétrie de la section de bobine.

11. Poignée de porte de véhicule selon l'une quelconque des revendications précédentes, dans laquelle le dispositif de détection est formé sur une carte multicouche, dans laquelle l'électrode de détection est disposée sur une couche de la carte multicouche et une électrode congruente à l'électrode de détection est formée sur au moins une autre couche de la carte multicouche comme électrode de blindage ou comme électrode de référence.

12. Poignée de porte de véhicule selon l'une quelconque des revendications précédentes, dans laquelle le dispositif de commande est configuré,
• pour connecter l'électrode du capteur à un potentiel de masse lorsque la bobine de transmission de champ proche est activée pour la transmission, et
• pour connecter la bobine de transfert de champ proche à un potentiel de masse lorsque l'électrode du capteur est activée pour la détection.
